# EUROPEAN PATENT SPECIFICATION

(11) **EP 4 511 827 B1**
(45) Date of publication and mention of the grant of the patent: **02.12.2026**
(21) Application number: 23722245.0
(22) Date of filing: 13.04.2023
(51) Int. Cl.: G08B 29/14, G08B 29/12

(54) **TESTING APPARATUS**
PRÜFVORRICHTUNG
APPAREIL DE TEST

(30) Priority: 19.04.2022 IN 202211023056
(43) Date of publication of application: 26.02.2025
(73) Proprietor: Johnson Controls Tyco IP Holdings LLP, Milwaukee, WI 53209 (US)
(72) Inventor: KUMAR, Amit, Milwaukee, Wisconsin 53209 (US); OJHA, Manoj Mohan, Milwaukee, Wisconsin 53209 (US); MEAH, Faruk, Milwaukee, Wisconsin 53209 (US); BENNETT, Steven, Milwaukee, Wisconsin 53209 (US); BHOSALE, Vishal, Milwaukee, Wisconsin 53209 (US)
(74) Representative: Meissner Bolte Nürnberg
(86) International application number: PCT/US2023/065712
(87) International publication number: WO 2023/205583

(56) References cited:
- EP-A2- 0 717 384
- JP-A- H1 069 587

## Description

### Cross-Reference to Related Applications

This application claims priority to Indian Provisional Application Number 202211023056 titled "TESTING APPARATUS," filed April 19, 2022.

### Technical Field

The present invention relates to a testing apparatus for use with a fire detection system.

### Background to the Invention and Prior Art

Fire detection systems often include a control panel and a number of networked devices connected to the control panel by network wiring. Such systems normally include multiple bases which are all connected to the network wiring to which the networked devices are mounted. Wiring faults are common during installation of such systems. A common mistake is incorrect wiring polarities connected to incorrect terminals on a base. In addition, there are several different types of base such as standard bases, isolator bases, and functional bases. All of these types of bases require different wiring connections, which further increases the chance of mistakes occurring. Most of the time, wiring issues are detected at the time of commissioning and it takes a lot of time and effort to locate the issue. Currently, multi-meters are the only common tool available to installers to tackle such issues. Examples for testing devices for fire detection systems are given in JPH1069587A (MATSUSHITA ELECTRIC WORKS LTD) and EP0717384 (HOCHIKI CO [JP]).

### Summary of Invention

According to an aspect of the present invention, there is provided a testing apparatus for testing correct wiring, for use with a fire detection system having a plurality of base units as claimed in claim 1.

The testing apparatus may comprise one or more second testers, each comprising an electronic circuit. Each of the second testers is configured to receive a voltage from a corresponding connector and provide an output independently of the configuration of the selector and based on the received voltage, the output indicating the connection state of a base terminal connected to the corresponding connector.

The testing apparatus may comprise one or more first indicators. Each of the first indicators is configured to receive the output from a corresponding tester and provide, based on the output, an indication of the connection state of the base terminal.

At least one of the first indicators may comprise one or more light sources.

At least one of the first indicators may comprise a first light source configured to output light of a first colour and a second light source configured to output light of a second colour. The first light source is configured to output light based on the output received from the tester indicating that the connection state is a first connection state, and the second light source is configured to output light based on the output received from the tester indicating that the connection state is a second connection state.

The selector may comprise a switch having a plurality of selectable positions. Each of the first testers may be configured to provide an output based on the position of the switch.

The testing apparatus may comprise a voltage monitor configured to detect a voltage of wiring to which the base unit is connected and provide an output indicating whether the voltage falls within a predetermined range.

The testing apparatus may comprise a fault detector configured to receive, from each of the testers, a second output indicating the connection state of the corresponding base terminal and, from the voltage monitor, an output indicating the voltage, and to provide, based on the received outputs, an output indicating whether a fault is present in the wiring or the connections of the base terminals.

The testing apparatus may comprise a second indicator configured to receive the output from the fault detector, and to provide, based on the output received from the fault detector, an indication of whether a fault is present in the wiring or the connections of the base terminals. The second indicator may comprise one or more light sources.

The second indicator may comprise a third light source configured to output light of a third colour and a fourth light source configured to output light of a fourth colour. The third light source is configured to output light based on the output indicating that a fault is present, and the fourth light source is configured to output light based on the output indicating that no fault is present.

The second indicator may comprise a sound output device.

The sound output device may be configured to output a sound based on the output indicating that a fault is present.

The testing apparatus may further comprise a power input configured to receive power from one or more of the connectors and provide power for the testing apparatus.

The testing apparatus may further comprise a power source configured to generate power for the testing apparatus.

Further features and aspects of the invention will be apparent from the appended claims.

### Brief Description of the Drawings

Further features and advantages of the present invention will become apparent from the following description, presented by way of example only, and by reference to the drawings, wherein like reference numerals refer to like parts, and wherein:
Figure 1 is a schematic diagram of a testing apparatus according to embodiments;
Figures 2A-2C are schematic diagrams of different bases;
Figure 3 is a block diagram of a testing apparatus according to embodiments;
Figure 4 is a circuit diagram of a tester according to embodiments;
Figure 5 is a circuit diagram of a switch according to embodiments; and
Figure 6 is a circuit diagram of a tester according to embodiments.

### Description of the Embodiments

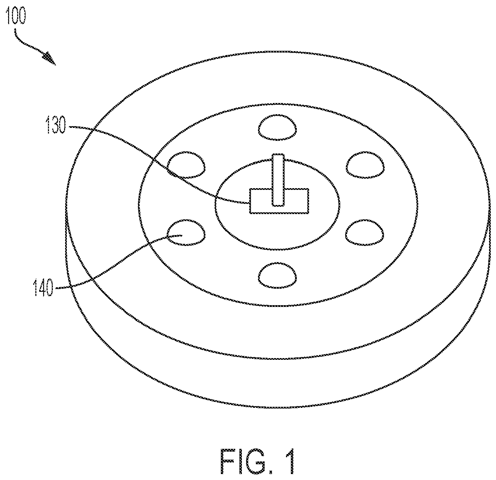

Figure 1 is a schematic diagram of a testing apparatus for testing the correct wiring of a base of a fire alarm system. Such a fire alarm system includes: a control panel (sometimes known as control & indicating equipment (CIE); addressable networked wiring extending from the control panel, the wiring including two lines: a positive line and a negative line; multiple bases (or base units) which are wired to the addressable network wiring and which include a plurality of terminals; and a number of addressable networked devices attached to the bases. It should be understood that the testing apparatus may also be used with fire alarm systems including networked wiring which is not addressable.

Once attached to a base, the networked device connects to the terminals of the base so as to be addressable by the control panel. For a new system, the wiring is installed first, extending from the location at which the control panel will be installed to the locations at which the addressable networked devices (smoke detectors, fire detectors, call points, notification devices, and the like) will be installed. In the embodiments described, the wiring is connected in a loop, with the ends connected together. The bases are then wired to the addressable networked wiring in the locations at which the addressable networked devices will be installed during the commissioning of the system. It should be noted that there is more than one type of base, and in this system, there are three different types of base, depending on the system specification. Once the bases have been wired in, the testing apparatus of the present invention can be connected to each base in turn to test whether it has been correctly wired, and to indicate the result of the test. The commissioning of the system happens later.

The testing apparatus 100 shown in Figure 1 includes a switch 130 which can switch the apparatus between different testing modes. The testing apparatus 100 also includes six indicators 140, each of which includes a multi-colour LED. In the present example, each of the LEDs can output either green light or red light.

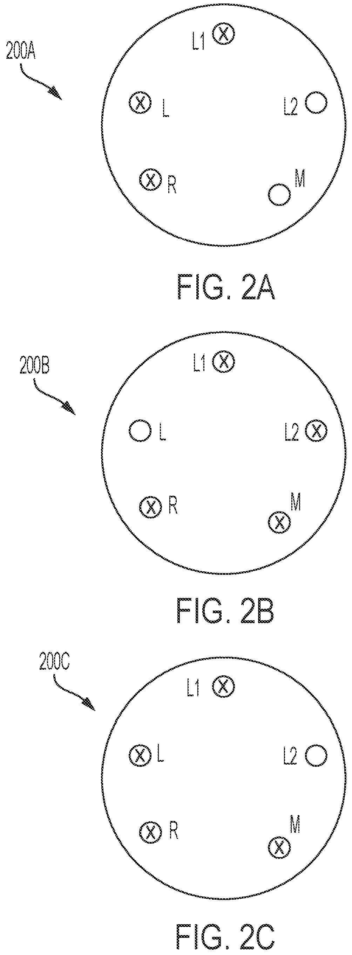

The testing apparatus 100 is a portable device, and has a structure which is designed to be attached to various types of bases, such as those described below in relation to Figures 2A-2C. Five of the indicator LEDs 140 output green light to indicate that a corresponding terminal on a given base is connected correctly. The sixth indicator LED 140 outputs green light when all of the terminals are connected correctly and the loop voltage is within a certain range. Hence, the testing apparatus can provide a user with direct indication of connection quality for multiple types of bases.

Figures 2A-2C shows examples of bases (or base units) which may be used with the testing apparatus of the present invention. Each base has five terminals (or base terminals), and only some of these may be connected in use. The terminals which are typically connected in use are indicated by an 'X'.

Figure 2A shows an example of a base without an isolator (referred to as a "non-isolator base"). For this type of base, terminal "L" is connected to the negative line of the networked wiring, and terminal "L1" is connected to the positive line of the networked wiring. Terminals "L2" and "M" are not wired. Terminal "R" is wired only if a remote indicator is required.

Figure 2B shows an example of a base including an isolator (referred to as an "isolator base"). For this type of base, terminal "L" is not wired. Terminal "L1" is connected to the positive line of the networked wiring. Terminals "L2" and "M" are connected to the negative line of the networked wiring. Terminal "R" is wired only if a remote indicator is required.

Figure 2C shows an example of a continuity base. For this type of base, terminals "L" and "M" are connected to the negative line of the networked wiring, and terminal "L1" is connected to the positive line of the networked wiring. Terminal "R" is wired only if a remote indicator is required.

**Table 1 below summarizes the correct connection of each terminal for each type of base.**

| Base | Correct Functions for Different Bases | | |
|---|---|---|---|
| Terminal | Non-isolator | Isolator | Continuity |
| Terminal L1 | Positive Line In & Out (Loop +VE) | Positive Line In & Out (Loop +VE) | Positive Line In & Out (Loop +VE) |
| Terminal L | Negative Line In & Out (Loop -VE) | Not Used (Floating) | Negative Line In & Out (Loop -VE) |
| Terminal L2 | Must Not Be Wired (Floating) | Negative Line Isolator In & Out (Loop -VE) | Must Not Be Wired (Floating) |
| Terminal M | Must Not Be Wired (Floating) | Negative Line Isolator In & Out (Loop -VE) | Negative Line In & Out (Loop -VE) |
| Terminal R | Remote LED Out, wired only if remote indicator is required | Remote LED Out, wired only if remote indicator is required | Remote LED Out, wired only if remote indicator is required |

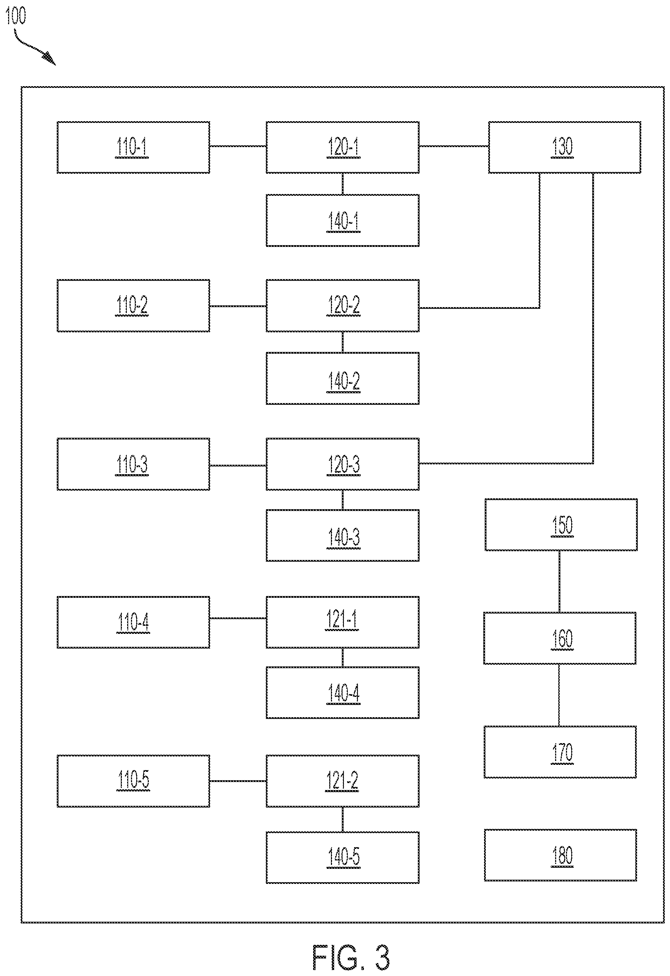

Figure 3 is a block diagram showing a testing apparatus. The testing apparatus 100 includes five connectors 110-1 to 110-5, three first testers 120-1 to 120-3, and a selector 130. In the present example, the testing apparatus 100 also includes two second testers 121-1 and 121-2, as well as a voltage monitor 150, a fault detector 160 and a second indicator 170.

Each of the connectors 110 is configured to be connected to a corresponding terminal of a base unit. In the present example, the connector 110-1 is connected to the "L" terminal, connector 110-2 is connected to the "L2" terminal and connector 110-3 is connected to the "M" terminal. The connector 110-4 is connected to the "L1" terminal and the connector 110-5 is connected to the "R" terminal.

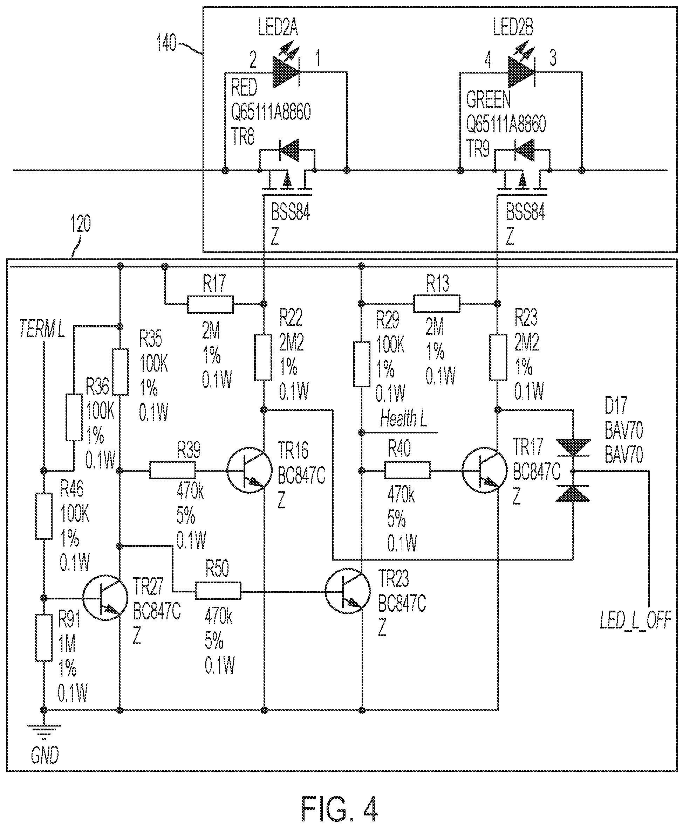

Each of the first testers 120 is connected to a corresponding connector 110 so as to receive a voltage from the corresponding connector 110. For example, the first tester 120-1 is connected to the connector 110-1. The first testers 120 may be implemented as circuits. An example of such a circuit is shown in Figure 4 below.

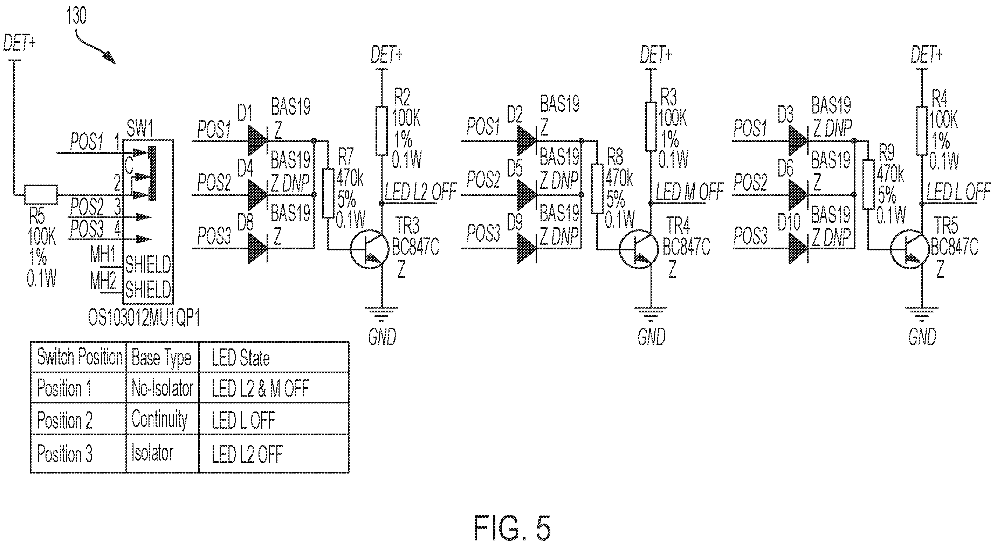

The selector 130 has a plurality of selectable configurations. Each of the configurations defines a testing mode of the testing apparatus 100. Each testing mode may correspond to a type of base (e.g. non-isolator, isolator or continuity). In the present embodiment, the selector 130 is a switch which has three selectable positions. Each of the positions corresponds to a different type of base. An example of a switch circuit is shown in Figure 5 below.

Each of the first testers 120 is configured to provide an output. The output from each first tester 120 depends on the testing mode of the testing apparatus 100, as well as the voltage the first tester 120 receives from the base terminal via the corresponding connector 110. The output from each first tester 120 indicates the connection state of the base terminal (i.e. whether the base terminal is correctly connected or incorrectly connected). Hence, the testing apparatus can test the connection states of base terminals on multiple types of bases.

As described above in relation to Figures 2A-2C, certain base terminals are not connected for certain types of base. For example, the "L" terminal is not connected for an isolator base, but is connected for non-isolator and continuity bases.

When the testing apparatus 100 is in an isolator base testing mode, tester 120-1 connected to the "L" terminal (via the connector 110-1) will not produce any output. However, when the testing apparatus 100 is in a non-isolator base testing mode or a continuity base testing mode, tester 120-1 which is connected to the "L" terminal will produce an output according to the voltage the tester 120-1 receives from the "L" terminal. The output indicates the connection state of the "L" terminal, i.e. whether the "L" terminal is correctly connected or incorrectly connected.

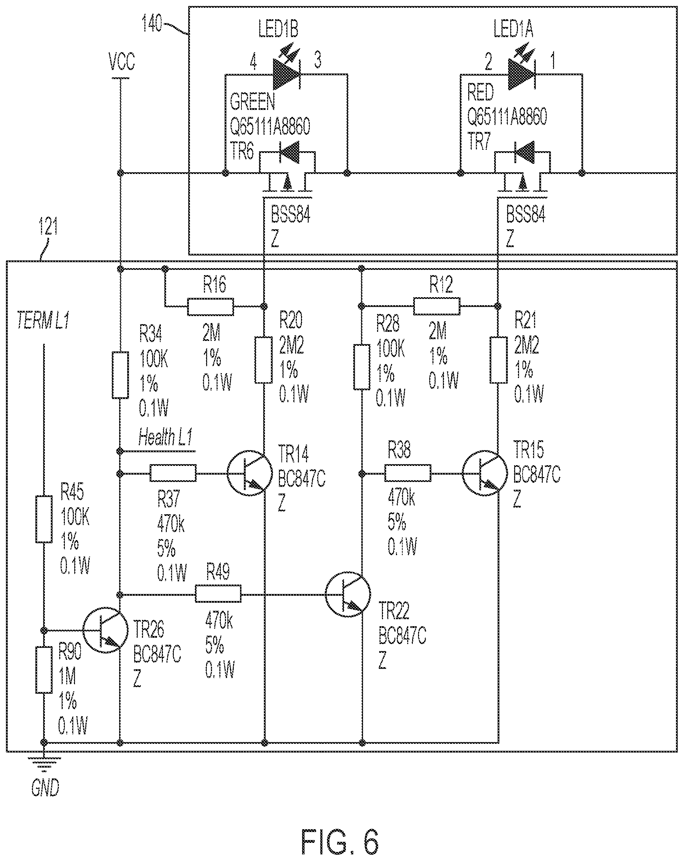

Each of the second testers 121 is connected to a corresponding connector 110 so as to receive a voltage from the corresponding connector 110. As shown in Figure 3, the second tester 121-1 is connected to the connector 110-4 and the second tester 121-2 is connected to the connector 110-5. The second tester 121 may be implemented as circuits. An example of such a circuit is shown in Figure 6 below.

Each of the second testers 121 is configured to provide an output. The output from each second tester 121 depends on the voltage the second tester 121 receives from the base terminal via the corresponding connector 110. Each of the second testers 121 is configured to be connected to a base terminal which is connected for all types of base, such as the "L1" terminal. Hence, the output from each second tester 121 is independent of the testing mode of the testing apparatus 100. The output from each second tester 120 indicates the connection state of the base terminal (i.e. whether the base terminal is correctly connected or incorrectly connected).

Each of the first indicators 140 is configured to receive the output from a corresponding one of the first testers 120 or second testers 121. For example, the first indicator 140-1 is configured to receive the output from the first tester 120-1.

Each of the first indicators 140 is configured to provide, based on the output from the corresponding tester, an indication of the connection state of the base terminal which is connected to the corresponding tester. In some embodiments, the first indicators 140 include one or more light sources, such as LEDs. This allows the testing apparatus 100 to provide a user with a visual indication of the connection states of the base terminals.

In the present embodiment, each of the first indicators 140 comprises a first LED (not shown) configured to output red light, and a second LED (not shown) configured to output green light. In other embodiments, the LEDs may be configured to output other colours of light.

The first LED is configured to output red light based on the output received from the corresponding tester indicating that the base terminal is incorrectly connected (e.g. the polarity of the voltage received from the base terminal is incorrect, or the base terminal is floating). This provides a user with a visual indication that the base terminal is incorrectly connected.

The second LED is configured to output green light based on the output received from the corresponding tester indicating that the base terminal is correctly connected. This provides a user with a visual indication that the base terminal is correctly connected.

The testing apparatus 100 also includes a voltage monitor 150 configured to detect a voltage of the wiring to which the base unit is connected. The voltage monitor 150 receives the voltage from one or more of the base terminals via the corresponding connectors 110. Connections between the voltage monitor 150 and the connectors 110 are not shown in Figure 3 for clarity. The voltage monitor 150 is configured to provide an output indicating whether the voltage falls within a predetermined range.

The testing apparatus 100 also includes a fault detector 160. The fault detector 160 is connected to each of the first and second testers 120, 121, and is configured to receive, from each of the first and second testers 120, 121, an output indicating the connection state of the base terminal connected to the corresponding tester. This output may be the same or different as the outputs provided from the first and second testers 120, 121 to the first indicators 140. Connections between the fault detector 160 and the first and second testers 120, 121 are not shown in Figure 3 for clarity.

The fault detector 160 is also connected to the voltage monitor 150, and is configured to receive the output from the voltage monitor 150. The fault detector 160 is configured to provide, based on the outputs received from the first and second testers 120, 121 and the voltage monitor 150, an output indicating whether a fault is present in the wiring, or the connections of the base terminals.

The testing apparatus 100 also includes a second indicator 170 configured to receive the output from the fault detector 160, and to provide, based on the output received from the fault detector 160, an indication of whether a fault is present in the wiring or the connections of the base terminals. In some embodiments, the second indicator 170 comprises one or more light sources, such as LEDs. This allows the testing apparatus 100 to provide a user with a visual indication of whether a fault is present.

In the present embodiment, the second indicator 170 comprises a first LED (not shown) configured to output red light, and a second LED (not shown) configured to output green light. In other embodiments, the LEDs may be configured to output other colours of light.

The first LED is configured to output red light based on the output received from the fault detector 160 indicating that a fault is present. This provides a user with a visual indication that there is a fault present in the system.

The second LED is configured to output green light based on the output received from the fault detector 160 indicating that no fault is present. This provides a user with a visual indication that the system is operating correctly.

In some embodiments, the second indicator comprises a sound output device, such as a buzzer, which is configured to output a sound based on the output received from the fault detector indicating that a fault is present. The second indicator may comprise a sound output device alternatively or in addition to the one or more light sources. In the present embodiment, the second indicator 170 comprises a buzzer in addition to the first and second LEDs.

In the present embodiment, the testing apparatus 100 comprises a power input 180 configured to receive power from one or more of the base terminals via the connectors 110 and provide power for the testing apparatus. For example, the power input 180 may supply power for driving the indicators 140.

In other embodiments, the testing apparatus 100 may include its own independent power source (not shown), such as a battery. This allows the testing apparatus 100 to be powered independently from the networked wiring.

Figure 4 shows an example of a tester circuit and a corresponding indicator circuit. In this example, the tester circuit 120 is configured to receive an input voltage, TERM_L, from the "L" terminal via a corresponding connector (not shown). The operating principles of the tester circuit may be applied to tester circuits configured to receive input voltages from other terminals such as the "L2" and "M" terminals.

When the testing apparatus is in a non-isolator base testing mode or a continuity base testing mode, the tester circuit 120 will produce an output according to the input voltage TERM_L. The output of the tester circuit 120 drives the indicator circuit 140.

The tester circuit 120 includes various components, in particular four transistors TR16, TR17, TR27 and TR23. The indicator circuit 140 includes a red LED, LED 2A, and a green LED, LED 2B. The on/off states of LED 2A and LED 2B are dependent on the on/off states of MOSFETs TR8 and TR9 respectively.

If TERM_L either remains floating or connected to the positive line, then transistor TR27 will be on, and hence transistor TR16 and MOSFET TR8 will be off and LED 2A will be on. Transistor TR23 will be off, hence transistor TR17 and MOSFET TR9 will be on and LED 2B will be off.

If TERM_L is connected to the negative line, then transistor TR27 will be off, and hence transistor TR16 and MOSFET TR8 will be on and LED 2A will be off. Transistor TR23 will be on, hence transistor TR17 and MOSFET TR9 will be off and LED 2B will be on.

When the testing apparatus is in an isolator base testing mode, the LEDs 2A, 2B will be off. This is explained in detail below with reference to Figure 5.

Figure 5 shows an example of a switch circuit which can be switched between a first position corresponding to a non-isolator base testing mode, a second position corresponding to an isolator base testing mode and a third position corresponding to a continuity base testing mode.

The switch circuit includes three transistors TR3, TR4, TR5. When the switch is in position 2, an isolator base testing mode is selected. In this case, transistor TR5 is on, which turns on MOSFETs TR8 and TR9 shown in Figure 4, hence by-passing LEDs 2A and 2B. Hence the LEDs for the tester circuit 140 shown in Figure 4 will be off when the switch is in position 2.

Figure 6 shows an example of a tester circuit and a corresponding indicator circuit. In this example, the tester circuit 121 is configured to receive an input voltage, TERM_L1, from the "L1" terminal via a corresponding connector (not shown). The operating principles of the tester circuit may be applied to tester circuits configured to receive input voltages from other terminals such as the "R" terminal.

The tester circuit 121 includes various components, in particular four transistors TR14, TR15, TR22 and TR26. The output of the tester circuit 121 drives the indicator circuit 140. The indicator circuit 140 includes a red LED, LED 1A, and a green LED, LED 1B. The on/off states of LED 1A and LED 1B are dependent on the on/off states of MOSFETs TR7 and TR6 respectively.

If TERM_L1 either remains floating or connected to the negative line, then transistor TR26 will be off, and hence transistor TR14 and MOSFET TR6 will be on and LED 1B will be off. Transistor TR22 will be on, hence transistor TR15 and MOSFET TR7 will be off and LED 1A will be ON.

If TERM_L1 is connected to the positive line, then transistor TR26 will be on, and hence transistor TR14 and MOSFET TR6 will be off and LED 1B will be on. Transistor TR22 will be off, hence transistor TR15 and MOSFET TR7 will be on and LED 1A will be off.

Various further modifications to the above described examples, whether by way of addition, deletion or substitution, will be apparent to the skilled person to provide additional examples, as long as they are encompassed by the appended claims.

## Claims

1. A testing apparatus (100) for testing correct wiring, for use with a fire detection system having a plurality of base units, wherein each base unit is a base which is wired to network wiring and includes a plurality of terminals, and configured that networked devices can be attached to said base unit, the testing apparatus (100) being a portable device configured to be attached to a base unit and comprising:
one or more connectors (110-1 to 110-5), each of the connectors (110-1 to 110-5) configured to be electrically connected to a corresponding base terminal (L, L1, L2, M, R) of a base unit, wherein the base terminal (L, L1, L2, M, R) is one of the plurality of terminals (L, L1, L2, M, R) on the base unit;
one or more first testers (120-1 to 120-3), each comprising an electronic circuit, wherein each of the first testers (120-1 to 120-3) is configured to receive a voltage from a corresponding connector (110-1 to 110-5); and
a selector (130) having a plurality of selectable configurations, each of the configurations defining a testing mode of the testing apparatus (100);
wherein each of the first testers (120-1 to 120-3) is configured to provide an output based on the configuration of the selector (130) and the received voltage, the output indicating the connection state of a base terminal (L, L1, L2, M, R) connected to the corresponding connector (110-1 to 110-5);
wherein the connection state indicates whether the base terminal (L, L1, L2, M, R) is correctly connected or incorrectly connected to the network wiring.

2. A testing apparatus (100) according to claim 1, comprising:
one or more second testers (121-1, 121-2), each comprising an electronic circuit, wherein each of the second testers (121-1, 121-2) is configured to receive a voltage from a corresponding connector (110-1 to 110-5) and provide an output independently of the configuration of the selector (130) and based on the received voltage, the output indicating the connection state of a base terminal (L, L1, L2, M, R) connected to the corresponding connector (110-1 to 110-5).

3. A testing apparatus (100) according to claim 1 or 2, comprising:
one or more first indicators (140, 140-1), wherein each of the first indicators (140, 140-1) is configured to receive the output from a corresponding tester (120, 121) and provide, based on the output, an indication of the connection state of the base terminal (L, L1, L2, M, R).

4. A testing apparatus (100) according to any one of claims 1 to 3, wherein at least one of the first indicators (140, 140-1) comprises one or more light sources.

5. A testing apparatus (100) according to claim 4, wherein at least one of the first indicators (140, 140-1) comprises a first light source (1A, 2A) configured to output light of a first colour and a second light source (1B, 2B) configured to output light of a second colour,
wherein the first light source (1A, 2A) is configured to output light based on the output received from the tester (120, 121) indicating that the connection state is a first connection state, and the second light source (1B, 2B) is configured to output light based on the output received from the tester (120, 121) indicating that the connection state is a second connection state.

6. A testing apparatus (100) according to any one of claims 1 to 5, wherein the selector (130) comprises a switch having a plurality of selectable positions, and each of the first testers (120-1 to 120-3) is configured to provide an output based on the position of the switch.

7. A testing apparatus (100) according to any one of claims 1 to 6, comprising a voltage monitor (150) configured to detect a voltage of wiring to which the base unit is connected and provide an output indicating whether the voltage falls within a predetermined range.

8. A testing apparatus (100) according to any one of claims 1 to 7, comprising a fault detector (160) configured to receive, from each of the testers, a second output indicating the connection state of the corresponding base terminal (L, L1, L2, M, R) and, from the voltage monitor (150), an output indicating the voltage, and
to provide, based on the received outputs, an output indicating whether a fault is present in the wiring or the connections of the base terminals (L, L1, L2, M, R).

9. A testing apparatus (100) according to claim 8, comprising a second indicator (170) configured to receive the output from the fault detector (160), and
to provide, based on the output received from the fault detector (160), an indication of whether a fault is present in the wiring or the connections of the base terminals (L, L1, L2, M, R).

10. A testing apparatus (100) according to claim 9, wherein the second indicator (170) comprises one or more light sources.

11. A testing apparatus (100) according to claim 10, wherein the second indicator (170) comprises a third light source configured to output light of a third colour and a fourth light source configured to output light of a fourth colour,
wherein the third light source is configured to output light based on the output indicating that a fault is present, and the fourth light source is configured to output light based on the output indicating that no fault is present.

12. A testing apparatus (100) according to any one of claims 9 to 11, wherein the second indicator (170) comprises a sound output device.

13. A testing apparatus (100) according to claim 12, wherein the sound output device is configured to output a sound based on the output indicating that a fault is present.

14. A testing apparatus (100) according to any one of claims 1 to 13, further comprising a power input (180) configured to receive power from one or more of the connectors (110-1 to 110-5) and provide power for the testing apparatus (100).

15. A testing apparatus (100) according to any one of claims 1 to 14, further comprising a power source configured to generate power for the testing apparatus (100).

## Patentansprüche

1. Prüfvorrichtung (100) zum Prüfen der korrekten Verdrahtung zur Verwendung mit einem Brandmeldesystem mit einer Vielzahl von Sockeleinheiten, wobei jede Sockeleinheit ein Sockel ist, der mit einer Netzwerkverdrahtung verdrahtet ist und eine Vielzahl von Anschlussklemmen einschließt und so ausgebildet ist, dass vernetzte Geräte an der Sockeleinheit angebracht werden können, wobei die Prüfvorrichtung (100) ein tragbares Gerät ist, das dazu ausgebildet ist, an einer Sockeleinheit angebracht zu werden, und Folgendes umfasst:
einen oder mehrere Verbinder (110-1 bis 110-5), wobei jeder der Verbinder (110-1 bis 110-5) dazu ausgebildet ist, elektrisch mit einer entsprechenden Sockelanschlussklemme (L, L1, L2, M, R) einer Sockeleinheit verbunden zu werden, wobei die Sockelanschlussklemme (L, L1, L2, M, R) eine der Vielzahl von Anschlussklemmen (L, L1, L2, M, R) an der Sockeleinheit ist;
einen oder mehrere erste Prüfer (120-1 bis 120-3), die jeweils eine elektronische Schaltung umfassen, wobei jeder der ersten Prüfer (120-1 bis 120-3) dazu ausgebildet ist, eine Spannung von einem entsprechenden Verbinder (110-1 bis 110-5) zu empfangen; und
einen Wahlschalter (130) mit einer Vielzahl von auswählbaren Konfigurationen, wobei jede der Konfigurationen einen Prüfmodus der Prüfvorrichtung (100) definiert;
wobei jeder der ersten Prüfer (120-1 bis 120-3) dazu ausgebildet ist, basierend auf der Konfiguration des Wahlschalters (130) und der empfangenen Spannung ein Ausgangssignal bereitzustellen, wobei das Ausgangssignal den Verbindungszustand einer mit dem entsprechenden Verbinder (110-1 bis 110-5) verbundenen Sockelanschlussklemme (L, L1, L2, M, R) anzeigt;
wobei der Verbindungszustand anzeigt, ob die Sockelanschlussklemme (L, L1, L2, M, R) korrekt oder nicht korrekt mit der Netzwerkverdrahtung verbunden ist.

2. Prüfvorrichtung (100) nach Anspruch 1, umfassend:
einen oder mehrere zweite Prüfer (121-1, 121-2), die jeweils eine elektronische Schaltung umfassen, wobei jeder der zweiten Prüfer (121-1, 121-2) dazu ausgebildet ist, eine Spannung von einem entsprechenden Verbinder (110-1 bis 110-5) zu empfangen und unabhängig von der Konfiguration des Wahlschalters (130) und basierend auf der empfangenen Spannung ein Ausgangssignal bereitzustellen, wobei das Ausgangssignal den Verbindungszustand einer mit dem entsprechenden Verbinder (110-1 bis 110-5) verbundenen Sockelanschlussklemme (L, L1, L2, M, R) anzeigt.

3. Prüfvorrichtung (100) nach Anspruch 1 oder 2, umfassend:
einen oder mehrere erste Anzeiger (140, 140-1), wobei jeder der ersten Anzeiger (140, 140-1) dazu ausgebildet ist, das Ausgangssignal von einem entsprechenden Prüfer (120, 121) zu empfangen und basierend auf dem Ausgangssignal eine Anzeige des Verbindungszustands der Sockelanschlussklemme (L, L1, L2, M, R) bereitzustellen.

4. Prüfvorrichtung (100) nach einem der Ansprüche 1 bis 3, wobei mindestens einer der ersten Anzeiger (140, 140-1) eine oder mehrere Lichtquellen umfasst.

5. Prüfvorrichtung (100) nach Anspruch 4, wobei mindestens einer der ersten Anzeiger (140, 140-1) eine erste Lichtquelle (1A, 2A), die dazu ausgebildet ist, Licht einer ersten Farbe auszugeben, und eine zweite Lichtquelle (1B, 2B), die dazu ausgebildet ist, Licht einer zweiten Farbe auszugeben, umfasst, wobei die erste Lichtquelle (1A, 2A) dazu ausgebildet ist, basierend auf dem von dem Prüfer (120, 121) empfangenen Ausgangssignal Licht auszugeben, das einen ersten Verbindungszustand anzeigt, und die zweite Lichtquelle (1B, 2B) dazu ausgebildet ist, basierend auf dem von dem Prüfer (120, 121) empfangenen Ausgangssignal Licht auszugeben, das einen zweiten Verbindungszustand anzeigt.

6. Prüfvorrichtung (100) nach einem der Ansprüche 1 bis 5, wobei der Wahlschalter (130) einen Schalter mit einer Vielzahl von auswählbaren Positionen umfasst und jeder der ersten Prüfer (120-1 bis 120-3) dazu ausgebildet ist, ein Ausgangssignal basierend auf der Position des Schalters bereitzustellen.

7. Prüfvorrichtung (100) nach einem der Ansprüche 1 bis 6, umfassend eine Spannungsüberwachungseinrichtung (150), die dazu ausgebildet ist, eine Spannung der Verdrahtung zu erfassen, mit der die Sockeleinheit verdrahtet ist, und ein Ausgangssignal bereitzustellen, das anzeigt, ob die Spannung innerhalb eines vorgegebenen Bereichs liegt.

8. Prüfvorrichtung (100) nach einem der Ansprüche 1 bis 7, umfassend eine Fehlerdetektionseinrichtung (160), die dazu ausgebildet ist, von jedem der Prüfer ein zweites Ausgangssignal, das den Verbindungszustand der entsprechenden Sockelanschlussklemme (L, L1, L2, M, R) anzeigt, und von der Spannungsüberwachungseinrichtung (150) ein Ausgangssignal, das die Spannung anzeigt, zu empfangen und
basierend auf den empfangenen Ausgangssignalen ein Ausgangssignal bereitzustellen, das anzeigt, ob ein Fehler in der Verdrahtung oder in den Verbindungen der Sockelanschlussklemmen (L, L1, L2, M, R) vorliegt.

9. Prüfvorrichtung (100) nach Anspruch 8, umfassend einen zweiten Anzeiger (170), der dazu ausgebildet ist, das Ausgangssignal von der Fehlerdetektionseinrichtung (160) zu empfangen und
basierend auf dem von der Fehlerdetektionseinrichtung (160) empfangenen Ausgangssignal eine Anzeige bereitzustellen, die anzeigt, ob ein Fehler in der Verdrahtung oder in den Verbindungen der Sockelanschlussklemmen (L, L1, L2, M, R) vorliegt.

10. Prüfvorrichtung (100) nach Anspruch 9, wobei der zweite Anzeiger (170) eine oder mehrere Lichtquellen umfasst.

11. Prüfvorrichtung (100) nach Anspruch 10, wobei der zweite Anzeiger (170) eine dritte Lichtquelle, die dazu ausgebildet ist, Licht einer dritten Farbe auszugeben, und eine vierte Lichtquelle, die dazu ausgebildet ist, Licht einer vierten Farbe auszugeben, umfasst,
wobei die dritte Lichtquelle dazu ausgebildet ist, basierend auf dem Ausgangssignal, das anzeigt, dass ein Fehler vorliegt, Licht auszugeben, und die vierte Lichtquelle dazu ausgebildet ist, basierend auf dem Ausgangssignal, das anzeigt, dass kein Fehler vorliegt, Licht auszugeben.

12. Prüfvorrichtung (100) nach einem der Ansprüche 9 bis 11, wobei der zweite Anzeiger (170) ein Schallausgabegerät umfasst.

13. Prüfvorrichtung (100) nach Anspruch 12, wobei das Schallausgabegerät dazu ausgebildet ist, basierend auf dem Ausgangssignal, das anzeigt, dass ein Fehler vorliegt, einen Schall auszugeben.

14. Prüfvorrichtung (100) nach einem der Ansprüche 1 bis 13, ferner umfassend einen Stromeingang (180), der dazu ausgebildet ist, Strom von einem oder mehreren der Verbinder (110-1 bis 110-5) zu empfangen und die Prüfvorrichtung (100) mit Strom zu versorgen.

15. Prüfvorrichtung (100) nach einem der Ansprüche 1 bis 14, ferner umfassend eine Stromquelle, die dazu ausgebildet ist, Strom zur Versorgung der Prüfvorrichtung (100) zu erzeugen.

## Revendications

1. Appareil de test (100) permettant de tester le câblage correct, destiné à être utilisé avec un système de détection d'incendie ayant une pluralité d'unités de base, dans lequel chaque unité de base est une base qui est raccordée au câblage réseau et comporte une pluralité de bornes, et qui est configurée de telle sorte que des dispositifs en réseau puissent être connectés à ladite unité de base, l'appareil de test (100) étant un dispositif portable configuré pour être connecté à une unité de base et comprenant :
un ou plusieurs connecteurs (110-1 à 110-5), chacun des connecteurs (110-1 à 110-5) étant configuré pour être connecté électriquement à une borne de base correspondante (L, L1, L2, M, R) d'une unité de base, dans lequel la borne de base (L, L1, L2, M, R) étant l'une parmi la pluralité de bornes (L, L1, L2, M, R) sur l'unité de base ;
un ou plusieurs premiers testeurs (120-1 à 120-3), comprenant chacun un circuit électronique, dans lequel chacun des premiers testeurs (120-1 à 120-3) est configuré pour recevoir une tension provenant d'un connecteur correspondant (110-1 à 110-5) ; et
un sélecteur (130) ayant une pluralité de configurations sélectionnables,
chacune des configurations définissant un mode de test de l'appareil de test (100) ;
dans lequel chacun des premiers testeurs (120-1 à 120-3) est configuré pour fournir une sortie sur la base de la configuration du sélecteur (130) et de la tension reçue, la sortie indiquant l'état de connexion d'une borne de base (L, L1, L2, M, R) connectée au connecteur correspondant (110-1 à 110-5) ;
dans lequel l'état de connexion indique si la borne de base (L, L1, L2, M, R) est correctement connectée ou incorrectement connectée au câblage réseau.

2. Appareil de test (100) selon la revendication 1, comprenant :
un ou plusieurs seconds testeurs (121-1, 121-2), comprenant chacun un circuit électronique, dans lequel chacun des seconds testeurs (121-1, 121-2) est configuré pour recevoir une tension provenant d'un connecteur correspondant (110-1 à 110-5) et pour fournir une sortie indépendamment de la configuration du sélecteur (130) et sur la base de la tension reçue, la sortie indiquant l'état de connexion d'une borne de base (L, L1, L2, M, R) connectée au connecteur correspondant (110-1 à 110-5).

3. Appareil de test (100) selon la revendication 1 ou 2, comprenant :
un ou plusieurs premiers indicateurs (140, 140-1), dans lequel chacun des premiers indicateurs (140, 140-1) est configuré pour recevoir la sortie provenant d'un testeur correspondant (120, 121) et fournir, sur la base de la sortie, une indication de l'état de connexion de la borne de base (L, L1, L2, M, R).

4. Appareil de test (100) selon l'une quelconque des revendications 1 à 3, dans lequel au moins l'un parmi les premiers indicateurs (140, 140-1) comprend une ou plusieurs sources de lumière.

5. Appareil de test (100) selon la revendication 4, dans lequel au moins l'un parmi les premiers indicateurs (140, 140-1) comprend une première source de lumière (1A, 2A) configurée pour émettre de la lumière d'une première couleur et une deuxième source de lumière (1B, 2B) configurée pour émettre de la lumière d'une deuxième couleur, dans lequel la première source de lumière (1A, 2A) est configurée pour émettre de la lumière sur la base de la sortie reçue du testeur (120, 121) indiquant que l'état de connexion est un premier état de connexion, et la deuxième source de lumière (1B, 2B) est configurée pour émettre de la lumière sur la base de la sortie reçue du testeur (120, 121) indiquant que l'état de connexion est un second état de connexion.

6. Appareil de test (100) selon l'une quelconque des revendications 1 à 5, dans lequel le sélecteur (130) comprend un commutateur ayant une pluralité de positions sélectionnables, et chacun des premiers testeurs (120-1 à 120-3) est configuré pour fournir une sortie sur la base de la position du commutateur.

7. Appareil de test (100) selon l'une quelconque des revendications 1 à 6, comprenant un moniteur de tension (150) configuré pour détecter une tension d'un câblage auquel l'unité de base est connectée et pour fournir une sortie indiquant si la tension se situe dans une plage prédéterminée.

8. Appareil de test (100) selon l'une quelconque des revendications 1 à 7, comprenant un détecteur de défaut (160) configuré pour recevoir, de chacun des testeurs, une seconde sortie indiquant l'état de connexion de la borne de base correspondante (L, L1, L2, M, R) et, du moniteur de tension (150), une sortie indiquant la tension, et
pour fournir, sur la base des sorties reçues, une sortie indiquant si un défaut est présent dans le câblage ou les connexions des bornes de base (L, L1, L2, M, R).

9. Appareil de test (100) selon la revendication 8, comprenant un second indicateur (170) configuré pour recevoir la sortie provenant du détecteur de défauts (160), et
pour fournir, sur la base de la sortie reçue du détecteur de défauts (160), une indication permettant de déterminer si un défaut est présent dans le câblage ou dans les connexions des bornes de base (L, L1, L2, M, R).

10. Appareil de test (100) selon la revendication 9, dans lequel le second indicateur (170) comprend une ou plusieurs sources de lumières.

11. Appareil de test (100) selon la revendication 10, dans lequel le second indicateur (170) comprend une troisième source de lumière configurée pour émettre de la lumière d'une troisième couleur et une quatrième source de lumière configurée pour émettre de la lumière d'une quatrième couleur, dans lequel la troisième source de lumière est configurée pour émettre de la lumière sur la base du signal indiquant qu'un défaut est présent, et la quatrième source de lumière est configurée pour émettre de la lumière sur la base du signal indiquant qu'aucun défaut n'est présent.

12. Appareil de test (100) selon l'une quelconque des revendications 9 à 11, dans lequel le second indicateur (170) comprend un dispositif de sortie sonore.

13. Appareil de test (100) selon la revendication 12, dans lequel le dispositif de sortie sonore est configuré pour émettre un son sur la base de la sortie indiquant qu'un défaut est présent.

14. Appareil de test (100) selon l'une quelconque des revendications 1 à 13, comprenant en outre une entrée d'énergie (180) configurée pour recevoir de l'énergie provenant d'un ou plusieurs parmi les connecteurs (110-1 à 110-5) et pour fournir de l'énergie destinée à l'appareil de test (100).

15. Appareil de test (100) selon l'une quelconque des revendications 1 à 14, comprenant en outre une source d'énergie configurée pour générer de l'énergie destinée à l'appareil de test (100).
